Europäisches Patentamt

**European Patent Office**

Office européen des brevets

(19)

(11) Publication number: **0 156 964**
A1

(12) **EUROPEAN PATENT APPLICATION**

(21) Application number: **84113846.4**

(22) Date of filing: **15.11.84**

(51) Int. Cl.⁴: **H 01 L 21/76**

(30) Priority: **18.11.83 US 553328**

(43) Date of publication of application: **09.10.85**
Bulletin 85/41

(84) Designated Contracting States: **DE FR GB IT NL**

(71) Applicant: **MOTOROLA, INC., 1303 East Algonquin Road, Schaumburg, Illinois 60196 (US)**

(72) Inventor: **Boland, Bernard W., 7539 E. Palm Lane, Scottsdale Arizona 85257 (US)**

(74) Representative: **Hudson, Peter David, Motorola Ltd. Patent and Licensing Operations - Europe Jays Close Viables Industrial Estate, Basingstoke Hampshire RG22 4PD (GB)**

(54) **Means and method for improved junction isolation.**

(57) An improved means and method for forming junction isolated device regions is described wherein there is provided a semiconductor substrate (50) in which has been etched a tub (52) corresponding to the desired location and depth of the device. In a preferred embodiment, the tub is filled with three successive epitaxial layers. The first layer (53), of opposite conductivity type and more lightly doped than the substrate, conformally coats the bottom (52a) and sidewalls (52b) of the tub (52). A second layer (54), generally doped to the solid solubility limit, is formed conformally within the first layer (53). This serves as a buried collector region and provides a surface accessible contact to the buried collector. The third epitaxial layer (55) fills the tub (52) and acts as the device forming region. Higher breakdown voltages, lower isolation junction capacitance, and a more economical manufacturing process result.

MEANS AND METHOD FOR IMPROVED JUNCTION ISOLATION

BACKGROUND OF THE INVENTION

Field of the Invention

This invention relates in general, to improved means and methods for manufacturing semiconductor devices and, more particularly, to improved means and methods for junction isolation in semiconductor devices.

Background Art

In the manufacture of semiconductor devices, particularly integrated circuits, it is frequently desired to isolate different device regions placed within the same semiconductor body. A commonly used method of accomplishing this is to surround individual device regions or groups of device regions by a P-N junction isolation region. For example, in an integrated circuit using NPN transistors, the N-type collector regions rest on a common P-type substrate. Additional P-type diffused regions extending from the surface of the semiconductor down to the substrate, are placed between the individual N-type collector regions. These are generally referred to as isolation diffusions or isolation walls. Thus, each N-type collector region is surrounded by a PN junction. This PN junction prevents the substrate from shorting the individual collector regions together, and generally reduces interaction between adjacent collector regions to negligible levels. This type of junction isolation scheme is well known in the art.

Despite its wide-spread use, the above illustrated junction isolation scheme suffers from a number of disadvantages. Among these are the following:

(1) Substantial amounts of die area are occupied by the vertical isolation diffusions separating each active device area;

(2) Generally, the substrate and vertical isolation diffusions must be very heavily doped. This leads to significant parasitic junction capacitance between, for example, the device collector regions and the continuation of the substrate and the isolation walls. This problem is particularly severe when highly doped buried collector regions are utilized.

(3) Collector to substrate (or to isolation wall) breakdown voltages are often less than desired because of the necessity of using highly doped substrates, sidewall diffusions, and/or buried collector diffusions.

(4) Additional processing steps are required to place buried layer regions beneath the collector regions. Further, it is difficult to align the subsequent vertical isolation sidewall diffusions with the buried collector regions which are hidden from view beneath the collector layer. Additional alignment tolerance must be provided.

(5) It is difficult to fabricate high resistivity epitaxial collector regions when highly doped buried layer regions are required, because of auto-doping during epitaxial layer growth.

While some of these problems may be avoided by using alternative techniques, such as dielectric isolation, these usually require additional expensive processing. Thus, a need continues to exist for improved means and methods for junction isolation in semiconductor devices. Accordingly, it is an object of the present invention to provide improved means and method for forming junction isolation regions in semiconductor devices.

It is a further object of the present invention to provide improved means and method for eliminating separate buried layer and isolation sidewall diffusions and associated processing steps from semiconductor devices and device manufacture.

It is an additional object of the present invention to provide junction isolation means and methods having higher voltage breakdown capabilities, particularly where buried layer regions are present.

It is a further object of the present inventon to provide improved means and method for junction isolation in which the capacitance of the isolation junction is reduced.

It is a still further object of the present invention to provide an improved means and method for junction isolation of semiconductor devices which allows device packing density to be increased.

## SUMMARY OF THE INVENTION

Attainment of the foregoing and other objects and advantages is achieved through the present invention wherein there is provided a substrate of a first conductivity and type having a first surface, a first U-shaped semiconductor region penetrating from the first surface into the substrate and of a second conductivity and type, a second U-shaped semiconductor region penetrating from the first surface into and laterally enclosed by the first U-shaped region and of a third conductivity and type, a third semiconductor region penetrating from the first surface into and laterally enclosed by the second U-shaped region and of a fourth conductivity and type, and wherein the third semiconductor region has an exposed surface approximately coplanar with the first surface and suitable for use in forming device regions. A blocking junction desirably exists between the substrate and the first U-shaped region. The first U-shaped region is desirably of a relatively low conductivity. The second U-shaped region is desirably of a relatively high conductivity and is adapted to function in the same manner as a buried collector region.

There is further provided a method for manufacturing junction isolated devices or device regions, comprising:

providing a semiconductor substrate of a first conductivity and type; providing on a surface of the substrate a masking layer having a window for etching; etching the substrate through the window to form a tub having an open top, sidewalls, and a bottom, and a predetermined bottom depth; forming on the sidewalls and bottom of the tub a first semiconductor isolation layer of a second conductivity and type; forming on the first isolation layer a second semiconductor isolation layer of a third conductivity and type; and forming on the second isolation layer a first device forming region of a fourth conductivity and type. The conductivity of the substrate and the first isolation layer are desirably such that a blocking junction exists therebetween. It is desirable that the etching step to form the tub be carried out so that the sidewalls of the tub slope ·inward toward the bottom. It is further desirable that the first and second isolation layers and the first device forming region are formed by epitaxial deposition. The combined thickness of the isolation layers and device forming region should equal or exceed the tub depth. The epitaxial deposition may be selective, that is, only occurring on the bottom and sidewalls of the tub, or, it may occur over the entire wafer including the masking layer. Those portions of the epitaxial layers which are located substantially above the original wafer surface are desirably removed by lapping, etching, or a combination thereof. It is desirable to use a masking/etching process in which the epitaxial semiconductor material is removed more rapidly than the masking layer material so that the masking layer serves as a lapping stop. The masking layer may be optionally removed before depositing the first isolation layer or before proceeding with further processing to form particular devices within the device forming region.

## BRIEF DESCRIPTION OF THE DRAWINGS

FIGS. 1A-B show, in simplified form, schematic cross-sections of, respectively, MOS and bipolar device structures employing junction isolation, according to the prior art.

FIGS. 2A-B show, in simplified form, schematic cross-sections of, respectively, MOS and bipolar devices employing junction isolation, according to the present invention.

FIGS. 3A-G show, in simplified form, schematic cross-sections of semiconductor device structures at different stages of manufacture, according to the present invention.

## . DETAILED DESCRIPTION OF THE DRAWINGS

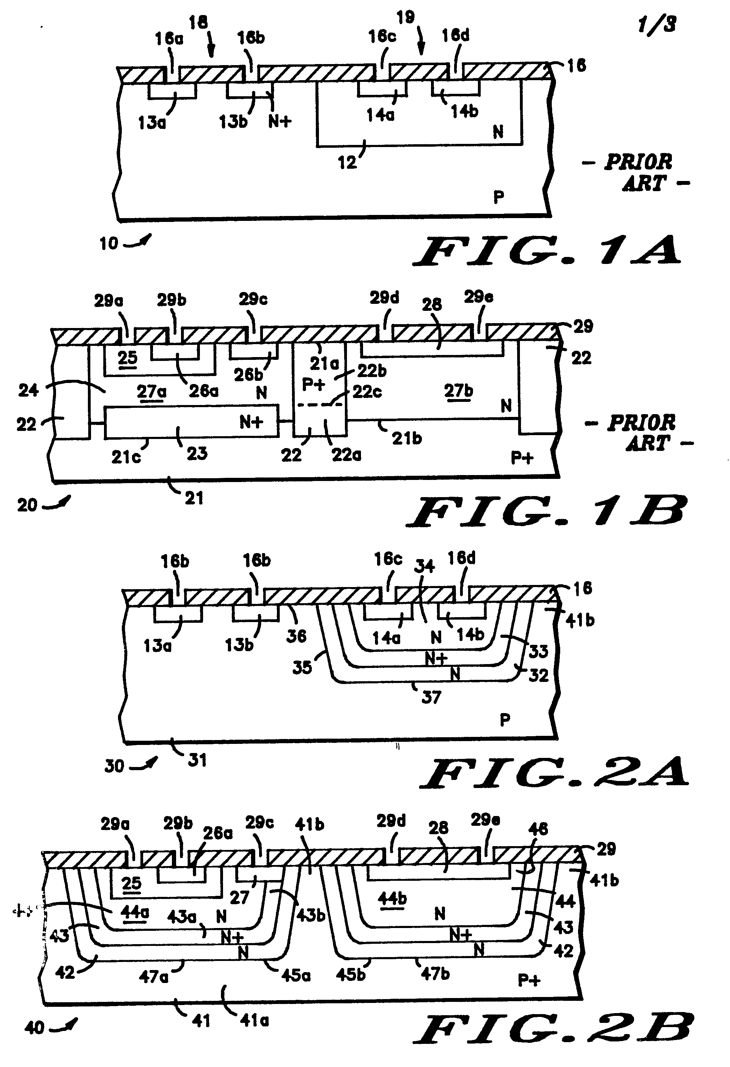

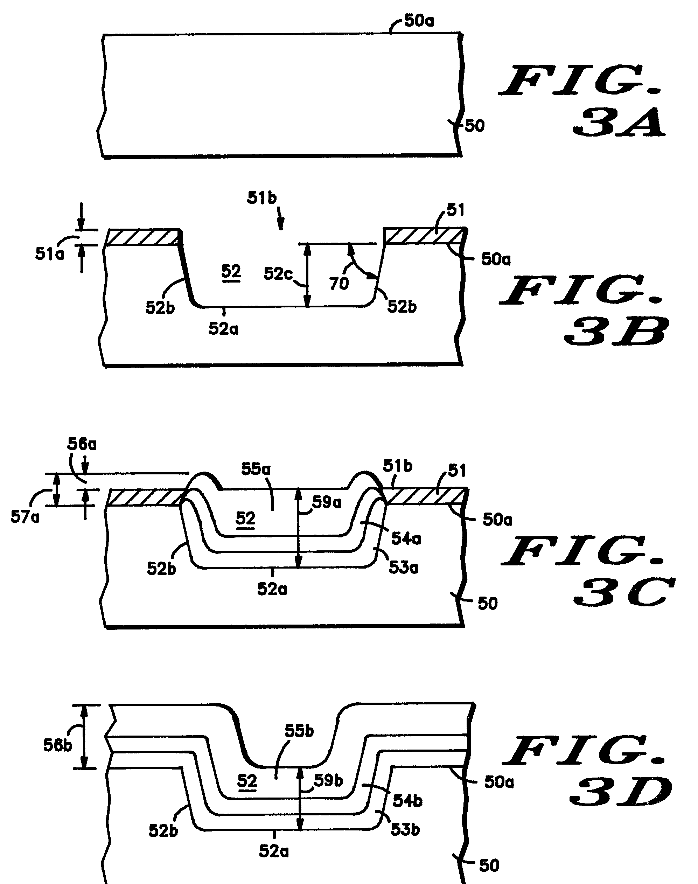

FIG. 1A shows, in simplified form, a schematic cross-section of device portion 10, according to the prior art, in which junction isolation is used in connection with MOS devices. P-type semiconductor substrate or wafer 11 has therein N-type region 12 in which have been placed $P^+$ source and drain regions 14a-b. P-type substrate 11 has therein $N^+$ source and drain regions 13a-b. Substrate 11 is covered with oxide layer 16 in which have been formed device contact openings 16a-d. For clarity, oxide layer 16 has been cross-hatched. A metallization layer (not shown) is ordinarily provided to interconnect the device regions. PN junction 17 isolates N-channel transistor 18 from P-channel transistor 19.

FIG. 1B shows, in a corresponding way, a junction isolation structure useful with bipolar devices. Device portion 20 is formed from P-type substrate 21 containing $N^+$ buried layer 23 and covered with N-type epitaxial layer 24 in which the bipolar devices are constructed. In the left of FIG. 1B, N-type epitaxial layer 24 serves as a collector region and contains P-type base region 25 and N-type emitter region 26. Contact to the collector region is made by means of $N^+$ collector contact 26b. In the right half of FIG. 1B is shown P-type diffused resistor region 28. Semiconductor wafer or substrate 21 is covered with oxide layer 29 which contains device contact windows 29a-e. Oxide layer 29 has been cross-hatched for clarity. $P^+$ vertical isolation walls or regions 22 extend from surface 21a through N-type epitaxial layer 24 to $P^+$ substrate 21. PN junctions 21b and 21c serve to isolate devices or device regions 27a-b from common substrate 21. Vertical isolation walls 22 serve to isolate device regions 27a-b from each other.

The prior art junction isolation schemes illustrated in FIGS. 1A-B have a number of significant disadvantages, for example, limited voltage breakdown capability, high junction capacitance (particularly where there are $N^+/P^+$ regions abutting), and relatively large area. Junction isolation schemes of the prior art are also complex to fabricate, particularly in the case of bipolar circuitry (see FIG. 1B). For example, a masking step is required to fabricate buried layer 23 before epitaxial layer 24 is grown. Following the growth of epitaxial layer 24 a separate alignment and masking step must be used to create isolation sidewall regions 22. Additionally, when epitaxial layer 24 must be quite thick, it is very difficult to drive isolation region 22 entirely through epitaxial layer 24 from surface 21a. In that situation, isolation region 22 is often formed by a combination of down-diffusion in region 22b from surface 21a and up-diffusion in region 22a from a mating $P^+$ region placed in substrate 21. The two diffusions meet approximately at dotted line 22c. This process requires a further masking and alignment step to create $P^+$ region 22a in substrate 21 prior to growth of epitaxial layer 24. While some of the deficiencies of prior art junction isolation schemes can be avoided by using non-junction isolation schemes, such as, dielectric isolation, such structures are generally more difficult to fabricate.

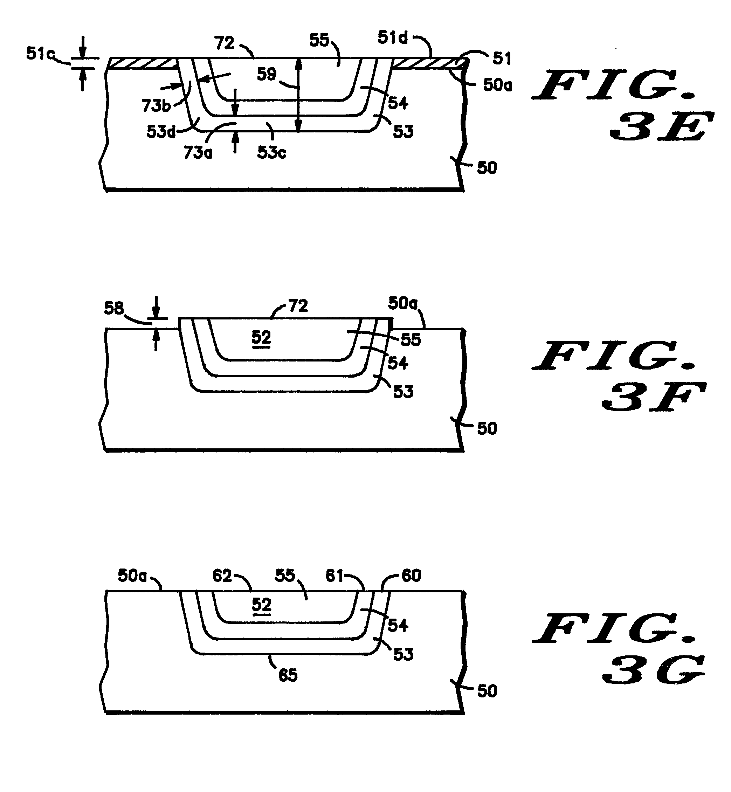

The above-noted and other deficiencies of prior art junction isolation systems can be avoided or substantially reduced by use of the structures illustrated in FIGS. 2A-B, according to the present invention. The present invention is described herein and illustrated in FIGS. 2A-B and FIGS. 3A-G as utilizing certain conductivity types and combinations. However, these conductivity types and combinations are for convenience in illustration. Those of skill in the art will recognize that the present invention is also applicable with other choices of conductivity types and combinations as well.

FIGS. 2A-B are simplified schematic cross-sectional views of device portions 30 and 40 suited, respectively, for use with MOS and bipolar devices, and similar in function to those illustrated in FIGS. 1A-B. Device portion 30 of FIG. 2A includes source drain regions 13a-b and 14a-b, as in the prior art. Surface 36 of substrate 31 of device portion 30 is coated with oxide 16 containing contact window 16a-b. Substrate 31, which is illustrated here as being P-type, has therein tub region 35 containing U-shaped N-type region 32 which desirably forms isolation junction 37 with substrate 31. $N^+$ region 33, also U-shaped, is placed within region 32. N-type device forming region 34 is placed within region 33. Device forming region 34 is similar in function to region 12 of FIG. 1A and is adapted to receive source drain regions 14a-b. It is generally desirable that N-type region 32 be lightly doped with respect to substrate 31 so that isolation junction 37 has a high breakdown voltage and comparatively low junction capacitance. It is also generally desirable that region 33 be highly doped so as to kill the gain of the parasitic transistor formed by P-type source drain regions 14a-b, N-type region 34, and P-type substrate 31.

FIG. 2B illustrates a structure, analogous to FIG. 1B, useful for junction isolation with bipolar circuitry. Device portion 40 has substrate 41 in which are formed tubs 45a-b. Tubs 45a-b have therein U-shaped regions 42, within which are formed U-shaped regions 43, and device forming regions 44. Regions 42, 43, and 44 extend to surface 46. Surface 46 is covered with dielectric layer 29 (e.g. an oxide layer) in which have been formed device contact windows 29a-e. Regions 44a-b are device forming regions in which conventional bipolar device structures may be constructed, for example, similar to those constructed in FIG. 1B.

At the left of FIG. 2B, device forming region 44a, which is illustrated by way of example as being N-type, forms the collector region of a bipolar transistor made up of base region 25 and emitter region 26. Collector contact region 27 desirably contacts both collector region 44a and U-shaped region 43. In the right half of FIG. 2B device forming region 44b is adapted to accept resistor region 28.

U-shaped regions 42 should generally be of opposite conductivity type to substrate region 41 so that isolation PN junctions 47a-b are formed between U-shaped regions 42 and substrate 41. It is desirable that U-shaped regions 42 be lightly doped with respect to substrate 41 in order to insure a high breakdown voltage and low junction capacitance. It is also desirable that U-shaped regions 43 be relatively highly doped, typically close to the solid solubility limit, so as to have extremely low resistance. Region 43a in the left half of FIG. 2B serves the same function as buried layer region 23 in the left half of prior art FIG. 1B. However, U-shaped region 43, comprising horizontal portion 43a and vertical portion 43b, has the advantage, relative to the prior art structures, that it extends to upper surface 46 of substrate 41 so that portion 43b may be contacted directly by collector contact 27.

By comparing FIGS. 2B and 1B it will be apparent to those of skill in the art that region 41a of substrate 41 serves the same function as substrate 21 in FIG. 1B, and that region 41b of substrate 41 of FIG. 2B serves the same function as vertical isolation walls 22 of FIG. 1B. It will be appreciated by those of skill in the art that the structure illustrated in FIG. 2B is particularly useful when it is desired that region 44 be quite thick, since the invented structure avoids the difficulties associated with creating deep isolation sidewalls, e.g. isolation regions 22 of FIG. 1B. It will be further appreciated by those of skill in the art that having lightly doped region 42 completely surround and separate device forming region 44 from substrate 41 substantially reduces the isolation junction capacitance relative to prior art structures, which, for example, have been illustrated in FIG. 1B.

FIGS. 3A-G illustrate a preferred embodiment of a method of manufacture of the device forming regions used to form device portions 30 and 40 of FIGS. 2A-B. In FIGS. 3A-B, semiconductor wafer or substrate 50 having upper surface 50a is coated with dielectric masking layer 51 having therein window or hole 51b. Window 51b is used to etch recess or tub 52 in substrate 50. Tub 52 has bottom 52a, sidewalls 52b, and depth 52c. Methods for forming masking layer 51 and etching tub 52 are well-known in the art. Masking layer 51 is desirably a refractory material, typically a refractory oxide or nitride such as, for example, silicon dioxide, silicon nitride, or a combination thereof. Tube 52 may have vertical or sloped sidewalls 52b. However, it is generally easier to obtain a more uniform coating of subsequent layers, e.g. layer 53, on sidewalls 52b if sidewalls 52b are sloped with angle 70 with respect to surface 50a of less than ninety degrees, preferably in the range 50 to 60 degrees.

Tub 52a is then filled with successive layers 53-55 of semiconductor material, preferably grown epitaxially with substrate 50. FIGS. 3C and D illustrate alternative methods by which this may be accomplished. In FIG. 3C semiconductor layers 53a, 54a, and 55a, are grown selectively, that is, so that they form on exposed semiconductor surfaces 52a-b of tub 52, but substantially not on surface 51b of masking layer 51. A method for accomplishing such selective deposition has been described in co-pending United States Patent application entitled "Method to Reduce Auto-Doping of Epitaxial Layers" by B. Boland filed on even date herewith.

Semiconductor layers 53a, 54a, and 55a of FIG. 3C are grown successively. Layer 53a substantially conformally coats bottom surface 52a and sidewalls 52b of tub 52. It is generally desirable that layer 53a be lightly doped with respect to substrate 50. Layer 54a is then grown on top of layer 53a also, substantially conformally. When it is desired that layer 54a function as a buried collector layer it should be highly doped, typically close to the solid solubility limit. In general, layer 53a should be of opposite conductivity type with respect to substrate 50. Device forming region 55a is formed within layer 54a so as to fill tub 52. Total thickness 59a of layers 53a plus 54a plus 55a must be at least equal to tub depth 52c, and is desirably equal to tub depth 52c plus masking layer thickness 51a.

Even though a selective technique is used for deposition of layers 53a, 54a, and 55a, it is generally the case that some portion of these layers will protrude above surface 50a and 51b, by for example, amounts 57a and 56a respectively. As will be subsequently described, it is desirable that these protrusions be removed.

An alternative method of filling tub 52 without the use of selective deposition is depicted in FIG. 3D. Masking layer 51 is first removed then semiconductor layers 53b, 54b and 55b are deposited on bottom 52a and sidewalls 52b of tub 52, and over surface 50a of substrate 50, to total thickness 59b which at least exceeds tub depth 52c. Deposition of layers 53b, 54b and 55b is not selective. Hence, substantially the same layer thickness also grows on surface 50a, as illustrated by thicknesses 56b. Techniques for forming the layers illustrated in FIGS. 3D are well known in the art. As was described earlier in connection with the discussion of FIG. 3C, it is essential that layer 53b conformally coat bottom 52a and sides 52b of tub 52. Layer 54b is formed within layer 53b and device forming region 55b is formed within layer 54 so as to at least fill tub 52.

In order that device forming region 55a-b be convenient for the construction of semiconductor device regions, it is desirable that those portions of layers 53a-b, 54a-b, and 55a-b which protrude above surface 50a or 51b, be removed. This can be accomplished by a combination of etching and lapping or polishing. If masking layer 51 is formed from a relatively hard refractory material such as silicon dioxide or silicon nitride or a combination thereof, then it can be used as a lapping and/or etching stop to assist in planarization of the wafer. FIG. 3E illustrates the situation after the protrusions of thickness 56a have been lapped, polished, and/or etched away. During this process, there is generally some thinning of masking layer 51 so that it now has residual thickness 51c above surface 50a of substrate 50. If masking layer 51 has been removed, as in FIG. 3D, then the structure of FIG. 3D is lapped, polished, and/or etched until surface 50a is re-exposed, as in FIG. 3G.

In FIG. 3E and subsequent figures, layers 53a-b, 54a-b, and 55a-b are referred to collectively as layers 53, 54, and 55, respectively. Device forming region 55 in FIG. 3E is now ready to receive further device regions as have been illustrated, for example, in FIGS. 2A-B. Device forming region 55 of FIG. 3E corresponds to device region 34 of FIG. 2A and regions 44a-b of FIG. 2B. Alternatively, as illustrated in FIG. 3F, remaining thickness 51c of layer 51 may be removed by etching, in which case layers 53, 54, and 55 will protrude above surface 50a by small amount 58. If desired (see FIG. 3G), additional polishing and/or etching steps may be used to planarize surface portions 60-62 of layers 53-55 in tub 52 with respect to surface 50a of substrate 50. As used herein, with respect to the alignment of surfaces 72 or 62 and surfaces 50a or 51d, the words substantially coplanar are intended to refer to the situations depicted in FIGS. 3E, 3F, or 3G.

To obtain junction isolation, one of layers 53, 54, and 55 must be of opposite conductivity type with respect to substrate 50. It is desirable that first layer or isolation region 53 be of opposite conductivity type with respect to substrate 50 and comparatively lightly doped, so that a PN junction is formed at 65 (FIG. 3G) to provide isolation between device forming region 55 and substrate 50. Under these circumstances, it is also desirable that second layer or isolation region 54 be relatively highly doped, generally near the solid solubility limit, to provide a low resistance buried collector region, or alternatively, to kill the gain or any parasitic substrate transistor which may be formed in connection with the device regions to be subsequently created within device forming region 55. In many applications, device forming region 55 will be more lightly doped than second layer or isolation region 54, and more lightly doped than substrate 50.

It is desirable that thickness 73b of sidewall portion 53d of layer 53 be approximately equal to thickness 73a of bottom portion 53c of layer 53. Similarly with the sidewall and bottom portions of layer 54. However, perfect equality is not required. It is convenient that thickness 73b and 73a of layer 53, and similarly for layer 54, have a ratio greater than one-half, that is, thickness 73b is greater than 0.5 times thickness 73a, preferably greater than 0.7 times thickness 73a.

Those of skill in the art will appreciate that the manufacturing method described above in connection with FIGS. 3A-G is much simplified as compared with prior art methods commonly employed for the construction of junction isolated devices, especially junction isolated bipolar devices. In particular, no separate masking or diffusion step is required to form a buried layer or gain-killing region (e.g. layer 54) under the epitaxial device forming region (e.g. region 55). Further, no separate masking and/or diffusion steps are required in order to obtain vertical isolation sidewalls, these being provided automatically by the isolation layers which conformally coat the sides of tub 52.

It is also no longer necessary to provide for alignment tolerance between the buried layer diffusions and the isolation sidewall diffusions, e.g. as was provided between regions 23 and 22 of FIG. 1B. This results in a substantial space-saving as compared to prior art structures and methods.

It will also be appreciated by those of skill in the art that isolation regions or layers 53 and 54, and device forming region 55 may be prepared in a single manufacturing sequence using, for example, epitaxial growth techniques, where variations in the doping type and/or conductivity of layers 53, 54, and 55 are accomplished by altering the type and amount of dopant introduced into the epitaxial reaction system during layer growth. This substantially simplifies the manufacturing process and results in the creation of fewer structural defects within the semiconductor wafer or substrate since the number of separate heating and cooling cycles can be reduced as compared to the prior art.

While the particular embodiments described herein have been illustrated in terms of particular conductivity types and combinations of conductivity types, it will be apparent that other conductivity types and combinations of conductivity types can also be used. In order that junction isolation exist, it is only necessary that one of layers 53, 54, or 55, be of opposite conductivity type as compared to substrate 50. Layer 53 may be the same or of opposite conductivity type with respect to substrate 50. This is also true of layers 42-44 and 32-34 respectively of FIGS. 2A-B as compared to substrates 41 and 31, respectively.

While only one of layers 53-55 need be of opposite conductivity type with respect to substrate 50, it is generally advantageous to have all three of layers 53-55 of the same conductivity type and opposite to the conductivity type of substrate 50. This simplifies the manufacturing process since it avoids reactor cross-contamination from trying to deposit different conductivity types in the same reactor. When layers 53-55 are all of the same type, then all three layers can be deposited in the same reactor during a single heating cycle. It is generally desirable also, that layer 53 be lightly doped as compared to substrate 50. This will increase the breakdown voltage of the isolation junction and reduce the parasitic isolation capacitance.

It is also generally desirable that layer 54 be of relatively high conductivity, usually close to the solid soluability limit, so as to present minimum series resistance and maximum carrier recombination velocity. Because layer 54 is U-shaped, portion 61 appears at surface 50a where it may be readily contacted (see FIG. 3G). This is particularly useful in forming high voltage devices where device forming region 55 must be quite thick and relatively lightly doped. U-shaped layer 54 then provides a low resistance collector contact which is directly accessible from front surface 50a of substrate 50 without additional masking or diffusion steps. This is a very substantial advantage over the prior art.

Thus, it is apparent that there is provided in accordance with this invention an improved means and method for junction isolation of semiconductor devices. It is further apparent, that the invented means and method permits the creation of device forming regions employing junction isolation, in which the isolation junction has improved voltage breakdown capabilities and reduced junction capacitance. Additionally, a more compact structure is obtained, particularly where thick epi-collector regions are required, because sidewall isolation diffusions and the associated alignment tolerances are no longer required. Further, the invented means and method is substantially simpler and more economical to manufacture.

Having thus described the invention, it will be apparent to those skilled in the art that various modifications can be made within the spirit and scope of the present invention. Accordingly, it is intended to encompass, within the claims which follow, all such modifications.

CLAIMS

1. A method for manufacturing a junction isolated region adapted for use in constructing semiconductor devices, comprising:

providing a semiconductor substrate (50) of a first conductivity and type;

providing on a surface of said substrate a masking layer (51) having at least one window (51b) for etching;

etching said substrate (50) through said window (51b) to form a tub (52) having an open top, sidewalls (52b), and a bottom (52a) of a first predetermined depth (52c);

forming on said sidewalls (52b) and said bottom (52a) of said tub (52) a first semiconductor isolation layer (53) of a second conductivity and type;

forming on said first semiconductor isolation layer (53) a second semiconductor isolation layer (54) of a third conductivity and type; and

forming on said second semiconductor isolation layer (54) a semiconductor region (55) of a fourth conductivity and type adapted for use in constructing semiconductor devices.

2. The method of claim 1 wherein said second type is opposite said first type and the same as said third and fourth types.

3. The method of claim 1 wherein said second conductivity and said fourth conductivity are less than said third conductivity.

4. The method of claim 3 wherein said second conductivity is less than said first conductivity.

5. The method of claim 1 wherein said first, second, and third forming steps further comprise forming said first isolation layer(53) to have a first thickness (73a) on said bottom of said tub, forming said second isolation layer (54) to have a second thickness on said bottom of said tub, and forming said semiconductor region (55) to have a third thickness on said bottom of said tub, and wherein the sum (59) of said first, second, and third thicknesses at least equals said depth (52c) of said tub.

6.    The method of claim 5 wherein said first forming step further comprises forming said first semiconductor isolation layer (53) to have a first sidewall thickness on said sidewalls of said tub (52), and wherein said first sidewall thickness is at least equal to a predetermined fraction of said first thickness on said bottom (52a) of said tub (52), said predetermined fraction being not less than 0.5.

7.    The method of claim 6 wherein said predetermined fraction is not less than 0.7.

8.    The method of claim 5 wherein said first (53) and second (54) semiconductor isolation layers and said first semiconductor region (55) are formed sequentially in an epitaxial deposition system by varying the relative concentration of dopant material to silicon source material during epitaxial deposition.

9.    The method of claim 1 wherein said etching step comprises etching said tub (52) to have sloping sidewalls (52b) so as to be narrower at said bottom (52a) than at said top, so that said sloping sidewalls (52b) have an angle with respect to the plane of said surface (50a) of said substrate (50) substantially in the range of 50 to 60°.

10. A junction isolated high voltage semiconductor device structure comprising:

a semiconductor substrate (50) of a first conductivity and type having a first surface (50a);

a first U-shaped semiconductor region (53) penetrating from said first surface (50a) into said substrate (50) and of a second conductivity and type;

a second U-shaped semiconductor region (54) penetrating from said first surface (50a) into said first U-shaped region (53), and laterally enclosed by said first U-shaped region (53), and of a third conductivity and type;

a third semiconductor region penetrating from said first surface (50a) into said second U-shaped region (54), and laterally enclosed by said second U-shaped region (54), and of a fourth conductivity and type, and wherein said third semiconductor region (55) has an exposed surface (62, 72) substantially coplanar with said first surface (50a); and

wherein said first U-shaped region (53) has a conductivity less than said second U-shaped region (54) and less than said substrate (50).

— PRIOR ART —

*FIG. 1A*

— PRIOR ART —

*FIG. 1B*

*FIG. 2A*

*FIG. 2B*

FIG. 3A

FIG. 3B

FIG. 3C

FIG. 3D

51c

72    55    51d    51

59    50a

73b

73a    53c    53d    54    53    50

**FIG. 3E**

58    72    50a

52    55

54    53    50

**FIG. 3F**

50a    62    55    61    60

52    54    53

65    50

**FIG. 3G**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 370 995 (C.L. LOWERY et al.)<br>* Column 5, line 38 - column 6, line 22 * | 1,2,5,8 | H 01 L 21/76 |
| X | GB-A-2 065 370 (DAINI SEIKOSHA)<br>* Page 3, lines 9-86 * | 1,2,5 | |
| A | GB-A-1 326 432 (KOGYO GITJUTSUIN)<br>* Page 3, lines 72-104 * | 1 | |

TECHNICAL FIELDS SEARCHED (Int. Cl.4)

H 01 L 21/76
H 01 L 27/04

The present search report has been drawn up for all claims

| Place of search | Date of completion of the search | Examiner |
|---|---|---|
| BERLIN | 05-02-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82